**Europäisches Patentamt**

**European Patent Office**

**Office européen des brevets**

(19)

(11) Publication number : **0 327 322 B1**

# (12) EUROPEAN PATENT SPECIFICATION

(45) Date of publication of patent specification :
31.08.94 Bulletin 94/35

(51) Int. Cl.⁵ : **H04N 7/137, H04N 7/13**

(21) Application number : **89300946.4**

(22) Date of filing : **01.02.89**

(54) **Decoding apparatus.**

(30) Priority : **05.02.88 JP 25377/88**

(43) Date of publication of application :
**09.08.89 Bulletin 89/32**

(45) Publication of the grant of the patent :
**31.08.94 Bulletin 94/35**

(84) Designated Contracting States :
**AT DE FR GB NL**

(56) References cited :
**EP-A- 0 159 879**
**EP-A- 0 185 533**
**PATENT ABSTRACTS OF JAPAN, vol. 10, no. 347 (E-457)(2403), 21 November 1986; &**
**JP-A-61147690**

(73) Proprietor : **SONY CORPORATION**
**7-35 Kitashinagawa 6-chome**
**Shinagawa-ku**
**Tokyo 141 (JP)**

(72) Inventor : **Kondo, Tetsujiro**
**c/o Sony Corporation**
**7-35 Kitashinagawa 6-chome**
**Shinagawa-ku Tokyo (JP)**

(74) Representative : **Ayers, Martyn Lewis Stanley et al**
**J.A. KEMP & CO.**
**14 South Square**
**Gray's Inn**
**London WC1R 5LX (GB)**

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

**Description**

The present invention relates to a decoding apparatus for receiving a transmitted image or picture signal and reproducing original image data and, more particularly, to a decoding apparatus for receiving transmission image data compression-encoded into image data with the bit number less than that of the original image data and reproducing the original image data.

Image data are quantized with eight bits, for example. In this case, to compress its data amount, the datum of each pixel is encoded with the bit number smaller than the original quantization bit number for transmission. As a simple example, only upper two bits of an eight-bit pixel datum are transmitted. On the reception side, for the encoded code of two bits, a reproduction level is represented by the central value in the region of each level.

The dynamic range of (0 to 255) that the original eight-bit quantization datum has is divided into four parts and the 2-bit encoded code is assigned to the region of each level as follows.

| Original signal | Encoded code | Decoded value |
|---|---|---|
| 255<br>\|<br>192 | (11) | 224 |
| 191<br>\|<br>128 | (10) | 160 |
| 127<br>\|<br>64 | (01) | 96 |
| 63<br>\|<br>0 | (00) | 32 |

Conventionally, since the original signal having 256 levels is represented by four levels, there is a problem such that quantization distortion is large.

In order to eliminate the above-mentioned disadvantage in the prior art, the present applicant has proposed an adaptive dynamic range encoding system (hereunder referred to as "ADRC system") as a compression system of a digital video signal in the level direction (MR 86-43 reported on December 11, 1986 at the Institute of Electronics and Communication Engineers of Japan,which is an incorporated body).

The ADRC system is an encoding system using the strong time and spatial correlation that a television signal has.

Specifically, if an image is divided, each block generally has only a small dynamic range due to local correlation. For this reason, in this ADRC system, an image is divided into blocks, a dynamic range of each block is obtained, and an adaptive requantizing of a pixel datum is done according to the dynamic range. As a result, each pixel datum is compressed into a datum with a less bit number than its original bit number.

For methods for dividing an image into blocks, the division in the horizontal direction (one-dimensional ADRC),the division in a rectangular area in the horizontal and vertical directions (two-dimensional ADRC) and the division in consideration of a space region over plural frames (three-dimensional ADRC) have been proposed (for example, refer to Japanese Patent Application Disclosure Nos. 61-144990, 61-144989 and 62-926620, which are laid open to public inspection or to EP-A-0 185 533).

In the three-dimensional ADRC, a movement detection between two frames is done for every block and data of a subsequent frame are not sent in a still block to perform the so-called "frame dropping". In this way, more efficient encoding can be done. In this case, a one-bit-movement-information code is needed for every block. However, in a still area, data compression of 1/2 can be made.

For the bit number allocation for every block at the time of requantizing, there has been proposed a system in which the allocated bit number for every block is changed depending on the magnitude of a dynamic range of each block (hereunder called "variable-length ADRC" for which Japanese Patent Application Disclosure No. 61-147689 or EP-A-0 186 444 laid open to public inspection can be referred) in addition to a system in which the quantization step size is varied depending on the dynamic range of each block as a constant value less than the bit number of the original pixel datum (hereunder called "fixed-length ADRC" to which the above-cited Patent Application Disclosure Nos. 61-144990, 61-144989 and 62-926620 can be referred).

With the adoption of the above-menthoned ADRC systems, quantization distortion is reduced surely as compared with the system where the upper two bits of the original digital signal quantized with eight bits are selected and transmitted and an eight-bit datum is reproduced from said two-bit datum. However, in this ADRC system, quantization distortion is still apt to be present in a block with a large dynamic range, since data transmitted depending on the dynamic range are merely decoded on the decoder side.

Accordingly, it is an object of the present invention to provide a decoding apparatus which can eliminate the disadvantages of the conventional systems, such as the occurrence of relatively large quantizing error or distortion.

Another object of this invention is to provide an improved decoding apparatus in which quantizing error or distortion can be reduced without increasing the number of bits on the encoding side, that is the transmitted data amount.

Further object of this invention is to provide an improved decoding apparatus combined with an adaptive dynamic range coding apparatus.

Still another object of this invention is to provide an improved decoding apparatus combined with a coding apparatus allowing well balanced compression in a spatial and level direction and in which the noise due to the difference of the number of bits can be reduced.

According to the present invention, there is provided a decoding apparatus for decoding coded data transmitted from a coding apparatus, said decoding apparatus comprising:

fetching means for providing, from data input to the fetching means, input data adjacent an input datum to be decoded;

comparator means for comparing individually with the input datum to be decoded each of said adjacent input data provided by said fetching means and providing an output for each comparison;

generating means supplied with each output of said comparator means for generating on the basis of all of said outputs a correcting datum; wherein in use said decoding apparatus decodes said input datum on the basis of said input datum and said correcting datum.

Preferably the decoding apparatus is for use with digital video data coded in a block format, the block format coding allowing compression of the block data representing a group of picture elements, said coded data having an additional code for each of said respective blocks, said additional code being formed of at least two of the maximum value, the minimum value, and a signal corresponding to dynamic range information of digital video data of said picture elements in said block.

The fetching means may provide adjacent input data in the same block as that to which said input datum to be decoded belongs, said decoding apparatus further comprising adder means for adding said correcting datum to said input datum, means for decoding the output of said adder means according to said dynamic range information, and mixing means for mixing the decoded output of said adder means and one of said maximum and minimum values.

Alternatively the decoding apparatus may further comprise means for partially decoding transmitted data according to said dynamic range information and block separation means for forming said data input to the fetching means by arranging said partially decoded data into TV scanning order.

The above and other objects and features of the present invention will become apparent from the following detailed description and the appended claims with reference to the accompanying drawings.

Fig. 1 is a block diagram of a first embodiment of the present invention.

Figs. 2 and 3 are schematic diagrams for explaining the operation of Fig. 1.

Fig. 4 is a block diagram of one example of an adaptive dynamic range coding apparatus for explaining second and third embodiments of the present invention.

Fig. 5 is a schematic diagram for explaining a block as a unit which is subjected to a coding process by the coding apparatus of Fig.4.

Fig. 6 is a schematic diagram for explaining the operation of the apparatus shown in Fig. 4.

Fig. 7 is a block diagram of the second embodiment of the present invention.

Fig. 8 is a schematic diagram for explaining the operation of the embodiment of Fig. 7.

Fig. 9 is a block diagram of the third embodiment of the present invention.

Fig. 10 is a schematic diagram for explaining a principle of a spatial sub-sampling method.

Fig. 11 is a schematic diagram for explaining the defects of the spatial sub-sampling method.

Fig. 12 is a block diagram of an improved spatial sub-sampling coding apparatus.

Fig. 13 is a time chart for explaining the operation of the embodiment of Fig. 12.

Fig. 14 is a schematic diagram for explaining the operation of the above improved spatial sub-sampling method.

Fig. 15 is a block diagram of a decoding apparatus for decoding data transmitted from the coding apparatus of Fig. 12.

Fig. 16 is a block diagram of a coding apparatus according to the improved spatial sub-sampling coding combined with ADRC.

Fig. 17 is a block diagram of a fourth embodiment of the present invention.

Fig. 18 is a block diagram of one example of an adaptive adjacent sample data decoding circuit shown in Fig. 17.

Figs. 19, 20 and 21 are schematic diagrams for explaining the operation of the embodiment of Fig. 17.

In the entire drawings, the same reference numerals denote the same structural elements.

Hereunder embodiments of the present invention will be described referring to the drawings.

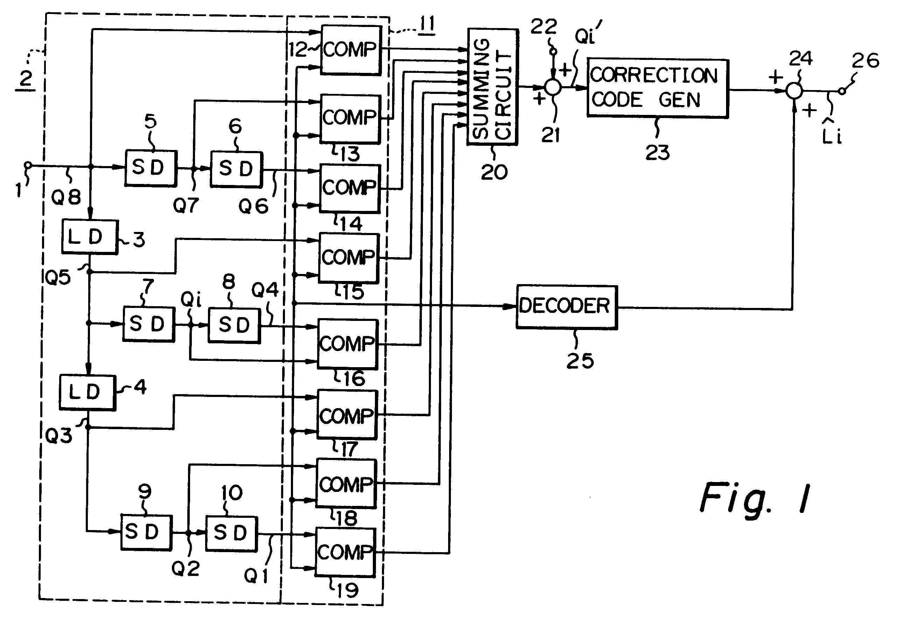

Fig. 1 shows a first embodiment of the invention, and the invention is applied to the case where two-bit quantization is carried out on the transmission side or the case where the upper two bits of an image signal quantized with eight bits are transmitted. Needless to say, the invention is applicable to the other bit numbers than the bit number of two bits. The image signal is a video signal, for instance.

Input data from an input terminal 1 are received in the order of television scanning.

An encoded code of two bits received at the input terminal 1 is supplied to a peripheral data fetching circuit 2 shown by a broken line. This fetching circuit 2 comprises: line delay circuits 3 and 4; and sample delay circuits 5, 6, 7, 8, 9 and 10 connected to the input terminal 1 and respective output terminals of the line delay circuits 3 and 4.

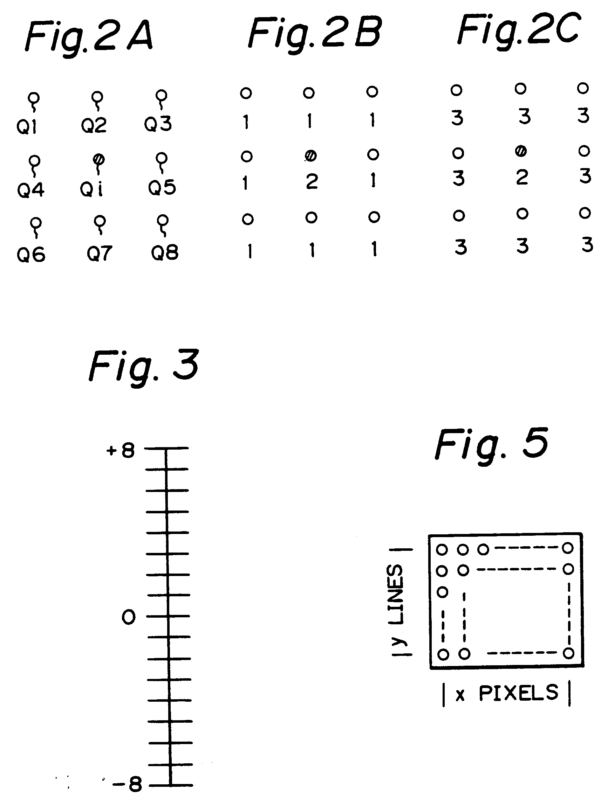

Said circuit 2 is a circuit to simultaneously fetch an encoded code $Q_i$ of an objective pixel indicated by a black dot and encoded codes $Q_1$ to $Q_8$ of eight peripheral pixels of the objective pixel in Fig. 2A. Namely, when the encoded code $Q_8$ is supplied to the input terminal 1, the $Q_5$ is output from the line delay circuit 3, the $Q_3$ is output from the line delay circuit 4, the $Q_7$ and $Q_6$ are output from the sample delay circuits 5 and 6, the $Q_i$ and $Q_4$ are output from the sample delay 7 and 8, and the $Q_2$ and $Q_1$ are output from the sample delay circuits 9 and 10.

The output data from the peripheral data fetching circuit 2 are supplied to a comparator 11 shown by broken line. Eight comparators 12 to 19 are included in the comparator 11. The encoded codes $Q_8$ to $Q_1$ of the peripheral pixels from the fetching circuit 2 are supplied to the comparators 12 to 19, respectively, and the encoded code $Q_i$ of the objective pixel is also commonly supplied thereto.

The comparators 12 to 19 compare the encoded code $Q_i$ of the objective pixel with the encoded codes $Q_j$ (j = 1, 2, ..., 8) of the peripheral pixels and generate the following comparison outputs:

when $Q_j > Q_i$: +1

when $Q_j = Q_i$: 0

when $Q_j < Q_i$: -1

The output signals of the comparator 11 are supplied to a summing circuit 20 and their outputs are added. For instance, as shown in Fig. 2B, when the encoded code $Q_i$ is 2 = (10) and all of the $Q_1$ to $Q_8$ are 1 = (01), the total value of the summing circuit 20 becomes -8. On the other hand, as shown in Fig. 2C, when encoded code $Q_i$ is 2 =(10) and all of the $Q_1$ to $Q_8$ are 3 = (11), the total value of the circuit 20 becomes +8. As shown in Fig. 3, the total value has seventeen kinds of values of (-8 to +8). However, when the $Q_i$ = 3 = (11), there are nine kinds (0 to -8) of distributions of the total values. When the $Q_i$ is 0 = (00), there are nine kinds (0 to +8) of distributions of the total values. Therefore, the total value can take 52 kinds of values as a whole in accordance with the encoded code $Q_i$ of the objective pixel.

The output signal of the summing circuit 20 is supplied to an adder 21. The datum of +8 is supplied from a terminal 22 to the adder 21. Therefore, the total values of (-8 to +8) are converted into (0 to +16) by the adder 21. The output signal $Q_i'$ of the adder 21 is supplied to a correction code generator 23. A correction code formed by the generator 23 is supplied to an adder 24. The decoded datum of the encoded data $Q_i$ of the objective pixel is supplied from a decoder 25 to the adder 24. A decoded value $\hat{L}_i$ is fetched to an output terminal 26 of the adder 24.

When the number of bits is two, the decoder 25 is an ROM (read-only memory) or a multiplying circuit to perform the decoding by a process of ($256/2^2$ x $Q_i$). Therefore, the output value of the decoder 25 is set at (0, 64, 128, 192).

The correction code generator 23 is a ROM or an arithmetic circuit to generate a correction code from the

EP 0 327 322 B1

output signal $Q_i'$ of the adder 21 by the following process.

$$\left\{ \frac{256 \times (Q_i' + 0.5)}{2^2 \times 17} + 0.5 \right\}$$

From the value of the above equation, the correction code of an integer is generated by a discarding process. When the total value becomes +8 as shown in the example of Fig. 2C, the output $Q_i'$ of the adder 21 is set to +16. The correction code generator 23 generates the correction code of the value of 62. Thus, a decoded value $\hat{L}_i$ which is obtained from the adder 24 becomes (128 + 62 = 190). As shown in the example of Fig. 2B when the total value becomes -8, the output $Q_i'$ of the adder 21 is set to 0 and the correction code generator 23 generates the correction code of the value of 2. Thus, the decoded value $\hat{L}_i$ which is derived from the adder 24 is set to (128 + 2 = 130).

Although conventionally represented merely by central value (e.g., 160), the level is converted into 17 kinds of fine reconstruction levels $\hat{L}_i$ on the basis of the values of the encoded codes of the peripheral pixel as shown in the foregoing example. Thus, the quantization distortion is reduced.

The present invention can be also applied to a decoding of the adaptive dynamic range coding (abbreviated to an ADRC) in which a picture plane is divided into a number of blocks (two-dimensional regions) and the quantization is executed so as to be adaptive to the dynamic range of each block.

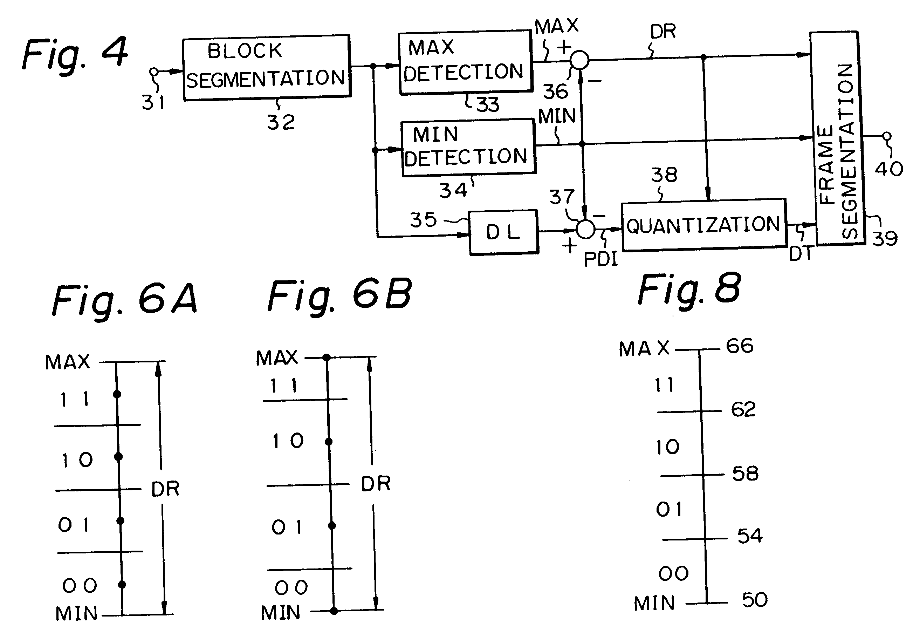

Next a second embodiment of the present invention will be explained with reference to the drawings. This embodiment is the case where the invention is applied to ADRC in which a video signal is converted into the construction of a two-dimensional block and quantized with two bits in a manner adaptive to the dynamic range of each block on the transmission side. For facilitating the understanding, description of the transmission side will be given referring to Fig. 4.

A digital video signal given to an input terminal 31 is supplied to a block segmentation circuit 32. The circuit 32 converts the order of the television scanning into the block order. One block has a two-dimensional area of (x pixels x y lines) as shown in Fig. 5. The output signal of the block segmentation circuit 32 is fed to a maximum value detector 33 for detecting a maximum MAX for every block, a minimum value detector 34 for detecting a minimum value MIN for every block and a delay circuit 35.

The detected maximum value MAX and minimum value MIN are supplied to a subtraction circuit 36. A dynamic range DR, which is a difference between the MAX and the MIN, is produced from the circuit 36. The delay circuit 35 delays data for a period of time necessary for detecting the MAX and the MIN. The MIN is subtracted from video data at a subtraction circuit 37 so as to provide a datum PDI with the MIN subtracted is given to a quantization circuit 38. The detected dynamic range DR has been supplied to the circuit 38, which performs a quantization adaptive to the DR to generate a two-bit encoded code DT. The quantization circuit 38 is composed of a ROM or an arithmetic circuit.

At the circuit 38, the dynamic range DR is divided into ($2^2 = 4$) as shown in Fig. 6A and said two-bit encoded code DT is allotted corresponding to a level range where the datum PDI with the minimum value subtracted belongs to. In the conventional decoding method of ADRC, the central value of each level range is coded as a representative level. The encoding shown in Fig. 6A is processing indicated by the following equation when the value of an encoded code DT obtained corresponding to an original level $L_i$ is $Q_i$:

$$Q_i = \left\{ \frac{(L_i - MIN) \times 2^n}{DR} \right\}$$

The above processing is for making an integer by omitting fractions. This is called "non-edge matching system".

Also, for the method of quantization, a method in which the maximum value MAX and the minimum value MIN are provided as decoded representative levels by the conventional decoding method as shown in Fig. 6B may be employed. This is called "edge matching system".

5

An additional code consisting of the dynamic range DR and the MIN and the encoded code DT are fed to a frame segmentation circuit 39, which performs encoding for error correction and an addition of a synchronization signal. Transmission data are produced at an output terminal 40 of the frame segmentation circuit 39.

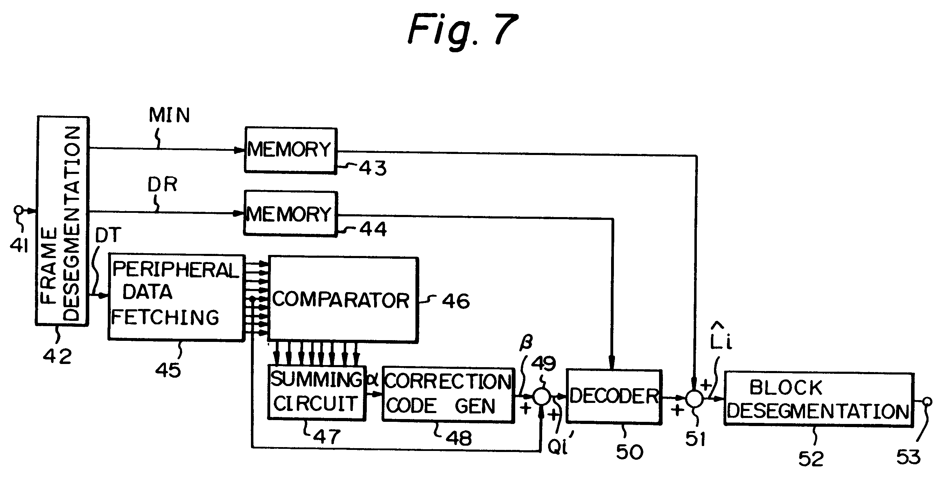

Fig. 7 shows a structure on the reception decoding side which receives the above-mentioned transmission data and decodes it. The present invention is applied to this reception side. The reception data given at an input terminal 41 are given to a frame desegmentation or separation circuit 42 which performs the decoding of an error correction code and provides the minimum value MIN, dynamic range DR and encoded code DT separately. The MIN and DR are supplied to memories 43 and 44, respectively.

The encoded code DT is given to a peripheral data fetching circuit 45 so that encoded codes of plural, for example, eight peripheral pixels around an objective pixel can be taken out. The circuit 45 is a circuit for fetching the encoded code $Q_i$ of the objective pixel shown by a black dot in Fig. 2A and the encoded codes $Q_1$ to $Q_8$ of the eight peripheral pixels simultaneously. The peripheral data fetching circuit 45 has a memory for the simultaneous fetching of the encoded codes of the peripheral pixels. Data of pixels in the same block with the objective pixel are taken out as peripheral data. In the case where a pixel at one end of a block is the objective pixel, encoded data of peripheral pixels are interpolated by pixels lying within the same block, since the peripheral pixels are contained in another block.

Output data from said circuit 45 are supplied to a comparator 46, which comprises eight comparison circuits. The encoded codes $Q_1$ to $Q_8$ from the circuit 45 and the encoded code $Q_i$ are supplied to the comparison circuits as shown in the drawing. Each of these circuits generates the following comparison output by comparing the code $Q_i$ and the code $Q_j$ (j =1, 2, ...,8):

$Q_j > Q_i$ : +1
$Q_j = Q_i$ : 0
$Q_j < Q_i$ : -1

The output signal of the comparator 46 is given to a summing circuit 47 for an addition of the comparison outputs. For example, as shown in Fig. 2B, a sum $\alpha$ of the circuit 47 is -8 when the encoded code $Q_i$ is 2 = (10) and when each of the $Q_1$ to $Q_8$ is 1 = (01). Also, when the code $Q_i$ is 2 = (10) and when each of the $Q_1$ to $Q_8$ is 3 = (11) as shown in Fig. 2C, the sum $\alpha$ of the summing circuit 47 is +8. In other words, the sum $\alpha$ takes 17 kinds of values ranging from -8 to +8.

The output signal $\alpha$ is supplied to a correction code generator 48. The generator 48 is composed of a ROM for performing a division of ($\beta = \alpha/17$). The correction code $\beta$ produced at the output of the generator 48 is given to an adder 49 and added to the encoded code $Q_i$ of the objective pixel.

The output signal $Q_i'$ of the adder 49 is fed to a decoder 50 to be subjected to decoding process. The dynamic range DR from a memory 44 is supplied to the decoder 50. This decoder 50 provides a decoded level depending on the output signal $Q_i'$ of the adder 49. The output signal of the decoder 50 is given to an adder 51. The adder 51 performs an addition of said output signal of the decoder 50 and minimum value MIN from a memory 43.

A decoded level $\hat{L}_i$ of the objective pixel having a finer level than the conventional decoded level is provided from the adder 51. The output signal of the adder 51 is supplied to a block desegmentation or separation circuit 52 in which the order of blocks is converted into that of the television scanning. The decoded level is taken out at an output terminal 53 of the block desegmentation circuit 52.

The decoding process in the above-mentioned second embodiment will be represented by the following equation:

$$Q_i' = Q_i + \beta = Q_i + (\alpha/17)$$

$$\hat{L}_i = \left( \frac{DR \times (Q_i' + 0.5)}{2^2} + MIN \right)$$

In the non ADRC decoding process, the reception encoded data $Q_i$ is employed in place of the $Q_i'$ in the above equation.

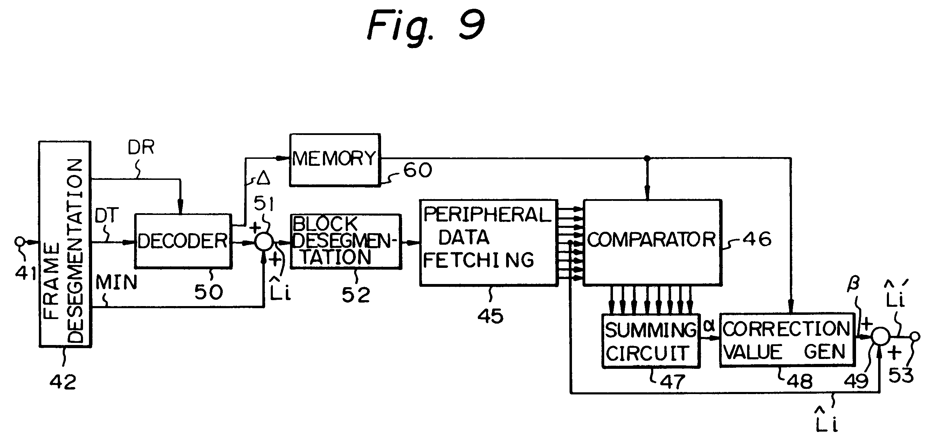

As an example, it is assumed that an original level of the objective pixel is represented by $L_i$ = 61 in a block with MIN = 50 and MAX = 66 as shown in Fig. 8. The encoding is made as follows:

$$Q_i = \left\lfloor \frac{(61 - 50) \times 2^2}{\cdot 16} \right\rfloor = 2$$

According to the conventional decoding process, the encoded code $Q_i$ is decoded as follows:

$$\hat{L}_i = \left\lfloor \frac{16 \times (2 + 0.5)}{2^2} + 50 \right\rfloor = 60$$

In this invention, in the case of ($\alpha$ = +8), for example, the following decoding is done:

$$Q_i' = 2 + (8/17) \doteqdot 2.47$$

$$\hat{L}_i = \left\lfloor \frac{16 \times (2.47 + 0.5)}{2^2} + 50 \right\rfloor = 61$$

Also, in the case of ($\alpha$ = -8), the decoding is done as follows:

$$Q_i' = 2 + (-8/17) \doteqdot 1.53$$

$$\hat{L}_i = \left\lfloor \frac{16 \times (1.53 + 0.5)}{2^2} + 50 \right\rfloor = 58$$

As a result, the decoded level $L_i$ according to the present invention takes finer steps than the conventional ones.

In the second embodiment, the decoding is carried out by referring only to pixels in the same block because other peripheral pixels become the ones in other blocks when the decoding of a pixel at one end of a block. However, there is a disadvantage that the correct decoding of the pixel at one end of the block cannot be done. Therefore, in a third embodiment shown in Fig. 9, an adaptive decoding is done referring to pixels even if these pixels are present in other blocks in the decoding operation.

Reception data is supplied through the input terminal 41 to the frame desegmentation circuit 42. Decoding of an error correction code is carried out at the circuit 42. The minimum value MIN, the dynamic range DR and the encoded code DT are produced separately at the frame desegmentation circuit 42.

The code DT and the dynamic range DR from the circuit 42 are supplied to the decoder 50. The output signal of the decoder 50 is given to the adder 51. A decoded level $\hat{L}_i$ (decoded value) of a pixel produced at the output of the adder 51 is given in the following equation:

$$L_i = \left\lfloor \frac{DR \times (Q_i + 0.5)}{2^2} \right\rfloor + MIN$$

7

Although the decoding is completed by the above-mentioned processing in the conventional ADRC, a block desegmentation and a conversion into the television scanning are performed, a spatial feature is extracted from the relationship between the decoded value of the objective pixel and its peripheral pixels, and an adaptive decoding is carried out in this embodiment.

A decoded value produced at the output of the adder 51 is supplied to the block desegmentation circuit 52. The block desegmentation circuit 52 converts data arranged in the order of blocks into the order of TV scanning. The output of the circuit 52 is supplied to the peripheral data fetching circuit 45.

At the circuit 45, decoded values of plural peripheral pixels, for example, eight peripheral pixels around the objective pixel are taken out. The circuit 45 takes out a decoded value $\hat{L}_i$ of the objective pixel indicated in the black dot in Fig. 2A and decoded values $\hat{L}_1$ to $\hat{L}_8$ of the eight peripheral pixels around the objective pixel simultaneously. For this purpose, the peripheral data fetching circuit 45 is constructed by a memory or a line-delay circuit and a sample delay circuit.

Output data from the circuit 45 are supplied to the comparator 46. A quantization step $\Delta$ (= $DR/2^2$) of each block from a memory 60 is given to the comparator 46. The step $\Delta$ is generated from the decoder 50. The comparator comprises eight comparison circuits. Each of these circuits is supplied with a corresponding one of the decoded values $\hat{L}_1$ to $\hat{L}_8$ of the peripheral pixels from the circuit 45 and an addition of the decoded value $\hat{L}_i$ of the objective pixel and $1/2\ \Delta$. Each comparison circuit compares $(\hat{L}_i + 1/2\ \Delta)$ and each decoded value $\hat{L}_j$ (j = 1, 2, ...,8) of the peripheral pixels to produce the following comparison outputs. In this case, when a pixel of a peripheral block is used as a reference pixel of the present block, the addition/subtraction of $1/2\ \Delta$ is performed since it is equivalent to the requantization of the peripheral pixel based on the dynamic range of the present block and the minimum value.

$$L_j > L_i + 1/2\Delta: +1$$
$$L_j = L_i + 1/2\Delta: 0$$
$$L_j < L_i + 1/2\Delta: -1$$

The output of the comparator 46 is supplied to the summing circuit 47 for the addition of comparison outputs. A sum $\alpha$ generated from the circuit 47 takes 17 kinds of values ranging from -8 to +8.

The output signal $\alpha$ and the quantization step $\Delta$ of the summing circuit 47 are supplied to the correction code generator 48. The generator 48 is composed of an ROM or an arithmetic circuit for performing the division of $\{\beta = (\alpha \times \Delta) \div 17\}$. The correction value $\beta$ produced from the generator 48 is given to the adder 49 and added to the encoded code (decoded value) $\hat{L}_i$ of said objective pixel. The output signal $\hat{L}_i'$ of the adder 49 is taken out from the output terminal 53 as a decoded output. The output signal $\hat{L}_i'$ with the correction value $\beta$ added has finer steps than those of a decoded value produced from the decoder 50.

The ADRC system shown in each of the above-mentioned embodiments is intended for the compression in the level direction. There is a technique called "intra-frame sub-sampling" for providing better compression in the combination with the ADRC system. The intra-frame sub-sampling is a system for thinning out pixel data periodically, for instance, in a line-quincunx fashion, to attain the compression in the spatial direction. As a result, this sub-sampling enables well-balanced compression in the combination with the compression in the level direction by the ADRC system.

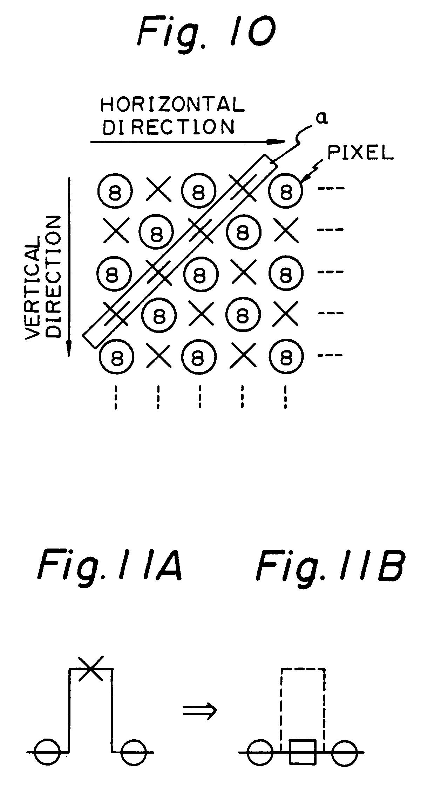

An example of the intra-frame sub-sampling is shown in Fig. 10.

As shown in Fig. 10, a method in which a pixel datum is transmitted every other pixel datum in the horizontal and vertical directions as indicated at O and pixel data shown at X are thinned out is generally employed. With this, when one pixel is represented by eight bits, transmission data can be compressed to 1/2 because it becomes equivalent to the case where all the pixels are transmitted with four bits.

In this case, the thinned-out pixel datum indicated at X is reproduced by an interpolation using pixel data shown at O and adjacent in the right-handed and left-handed directions to the pixel datum indicated at X and pixel data shown at O and lying in the upper and lower directions, because the transmitted pixel data indicated at O make a line-quincunx fashion.

However, when the pixel datum lying at the X position has correlation with the pixel data lying in the upper, lower, left-handed and right-handed directions in the case of the above-stated sub-sampling in the frame, the pixel datum at the X position obtained by the interpolation comes out excellently. In the absence of said correlation, the pixel datum at the X position cannot be reproduced. More specifically, referring to Fig. 11A when a video signal gives an abrupt level change as indicated by a solid line and there is no correlation between the pixel data at the X and O positions, pixel data produced by the interpolation takes a level shown □ in Fig. 11B, since information on the pixel data at the X positions does not exist. As a result, The pixel data at the X positions cannot be reproduced. This means that pixels lying on the line and consisting only of the pixel data at the X positions as shown at a solid line a of Fig. 10 cannot be reproduced.

This is because the information in the level direction of the pixel data at the X positions disappears to lack the balance in this direction by thinning out the pixel data at the X positions with the space compression based on sampling in space.

To solve this disadvantage, the inventor of the present application has proposed a novel transmission apparatus capable of performing well-balanced compression (refer to Japanese Patent Application No. 63-43363).

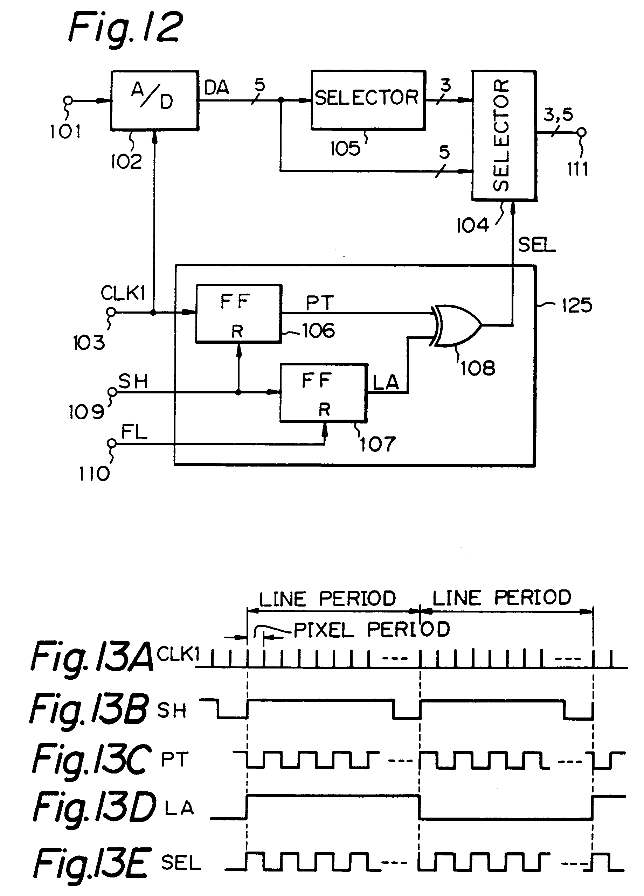

Fig. 12 shows an embodiment of the transmission apparatus and Fig. 13 shows a timing chart for describing the transmission apparatus.

Referring to Fig. 12, a video signal given through an input terminal 101 is supplied to an A/D (analog to digital) converter 102 and sampled by a clock CLK1 (Fig. 13A) fed via a terminal 103. The sampled value is converted to a five-bit datum (pixel datum) in this embodiment. The five-bit pixel datum DA of the A/D converter 102 is directly supplied to one input terminal of a selector 104 and a selector 105 for selecting upper three bits. Consequently, only the upper three bits of said datum DA are obtained and given to the other input terminal of the selector 104. A selection signal SEL is supplied from a selection signal generator 125 to the selector 104. A pixel datum is produced from the generator 125 so that a five-bit datum and a three-bit datum are obtained alternately in the horizontal direction and in the vertical direction for transmission from an output terminal 111.

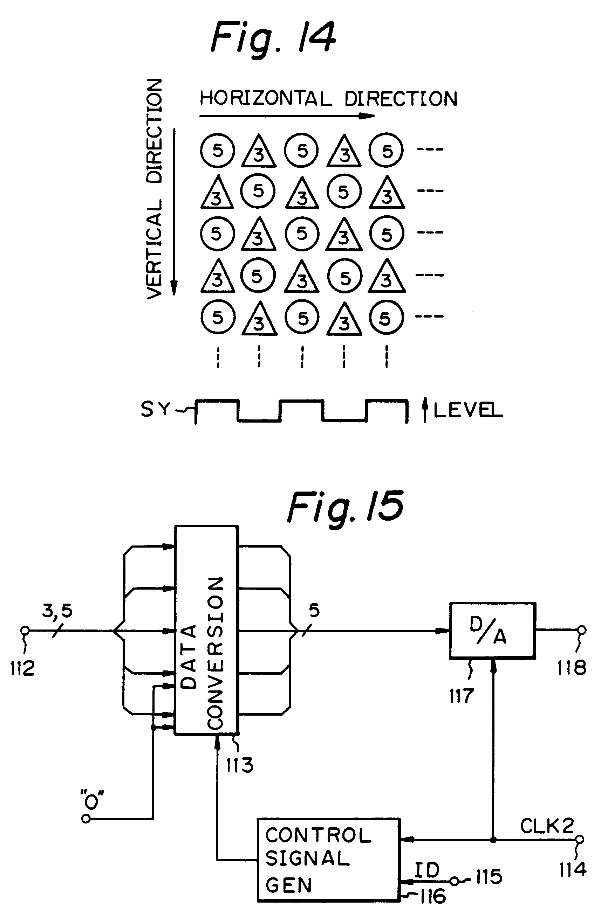

Fig. 14 is an explanatory diagram of output pixel data. Five-bit pixel data are indicated at O and three-bit pixel data are indicated at △. The pixels lying in the line-quincunx fashion have the same bit number.

Turning back to Fig. 12, the selection signal generator 125 is constructed by flip-flops 106 and 107 and an Exclusive OR circuit 108. The flip-flop 106 is triggered by the clock CLK1 given through the terminal 103 and reset by a signal SH (Fig. 13B) in synchronism with of the video signal fed through a terminal 109. A signal PT (Fig. 13), which is one-half of the period of the clock CLK1 and reset at the time of the beginning of a horizontal interval, is produced. The signal PT is supplied to the Exclusive OR circuit 108.

The flip-flop 107 is triggered by the signal SH and reset by a signal FL with a field period, which is given via a terminal 110. As a result, a signal whose state is inverted in every horizontal interval (Fig. 13D) is produced to be supplied to the circuit 108. For this reason, a signal in which the signal PT with its original phase and the signal PT with its inverted phase appear in every horizontal interval, that is, the selection signal SEL (Fig. 13E) is obtained.

For example, if a five-bit pixel datum is provided from the selector 105 in the presence of "1" of the selection signal SE and a three-bit pixel datum is given therefrom in the absence of "1" of the selection signal SE, transmission data of an array of five-bit pixel data and three-bit pixel data in a line-quincunx fashion as shown on a display of Fig. 14 are provided at an output terminal.

Referring to Fig. 15 which shows the decoding side, the three-bit or five-bit datum is given to a converter 113 composed of a shift register and its peripheral circuits, for instance.

Meanwhile, a clock CLk2 with a pixel period on the reception side is supplied to a conversion control signal generator 116 through a terminal 114, and a signal ID indicative of the head position of a horizontal interval or a field is given to the generator 116 though a terminal 115.

In the case of transmission of a digital video signal, no horizontal or vertical synchronization signal is sent. However, since the number of pixel samples per horizontal line is determined depending on a sampling frequency, the head of data of a horizontal line can be discriminated to provide the signal ID. Further, by keeping the signal ID and the clock CLK 2 at a constant phase relationship, the clock CLK2 can be synchronized with a pixel datum.

It is to be noted that the signal ID for discriminating the horizontal interval, field, etc, may be sent with data.

A conversion control signal corresponding to the selection signal SEL on the transmission side is developed based on the signal ID and the clock CLK2.

In the converter 113, when a pixel datum has five bits, the five-bit datum is directly output to a D/A converter 117 by said conversion control signal. Also, when the pixel datum has three bits, the three-bit datum is shifted so that this datum takes upper three bits of the five-bit shift register and "O's"are added to lower two bits to provide a total of five bits. This five-bit datum is output to the D/A converter 117. The clock CLK2 is supplied to the D/A converter 117, and the five-bit pixel datum is returned to an analog signal so that a demodulated video signal is produced at an output terminal 118.

Since a pixel datum is sent with five bits or three bits in the case of Fig. 12, this is equivalent to the case where all the pixel data are sent with four bits when viewed on a picture spatially integrated and is almost equivalent to the case where the eight-bit pixel data in the prior art shown in Fig. 10 are transmitted by thinning out into the line-quincunx fashion.

However, the prior art example of Fig. 10 causes a picture which is not reproduced as mentioned before because there are pixels which do not send data at all in consideration of the compression in the spatial direction.

In contrast, pixel data are sent securely in the above-mentioned transmission apparatus in consideration of not only the compression in the spatial direction but also of that in the level direction. Consequently, the apparatus enables well-balanced compression to eliminate the disadvantage in the prior art example.

A fourth embodiment shown below is an example in which the present invention is applied to a reception apparatus for receiving transmission data from a transmission apparatus based on the combination of the above-stated encoding system and the ADRC system.

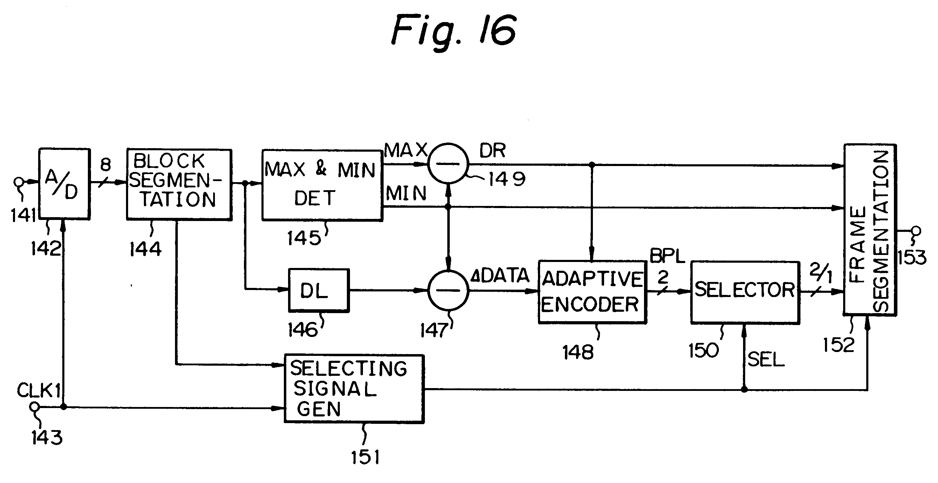

This transmission apparatus will be explained referring to Fig.16 first.

A picture signal from an input terminal 141 is given to an A/D converter 142, and each pixel is converted into a datum by a clock signal CLK1 from a terminal 143, for instance. The datum is supplied to a block segmentation circuit 144 and divided into block for every small block two-dimensional small block of 3 lines x 6 pixels, for example. Data of each block are fed to a minimum value/maximum value detector 145 to obtain a maximum value MAX and a minimum value MIN in each block.

Data of each block from the block segmentation circuit 144 are supplied to a subtraction circuit 147 through a delay circuit 146 for delaying for a period of delay time in the detector 145. The minimum value MIN in that block is given to the subtraction circuit 147. The minimum value MIN is subtracted from each pixel datum in said block to produce a difference datum $\Delta$DATA. The $\Delta$DATA is fed to an adaptive encoder 148. This encoder 148 corresponds to the quantization circuit 38 shown in Fig. 4.

Meanwhile, data of the maximum value MAX and the minimum value MIN of each block are supplied to a subtraction circuit 149 serving as a dynamic range detector, and a dynamic range DR in a block is detected as MAX-MIN = DR to be given to the adaptive encoder 148. At the encoder 148, the allocated bit number BITS in the block is selected depending on the dynamic range inputted, the difference pixel datum $\Delta$DATA from the subtraction circuit 147 is quantized once again into the bit number less than the original eight bits, for example, into a datum BPL compressed into two bits, and the datum BPL is produced from said encoder 148.

The output datum thus obtained is sent to a selector 150. A datum is produced at the selector 150 by a selection signal SEL from a selection signal generator 151 so that the bit numbers for horizontally and vertically adjacent pixels are different to be two bits and one bit in this example. A clock signal CLK1 is fed to the selection signal generator 151 through the terminal 143, and information on the time point of the start of a horizontal interval used in the block segmentation and information on the time points of the separation in the horizontal and vertical directions are supplied from the block segmentation circuit 144. As a result, the selection signal SEL is developed.

The two-bit pixel datum and one-bit pixel datum, the dynamic range DR in the block and the minimum value MIN in the block are given to a frame segmentation circuit 152. The selection signal SEL from the circuit 151 is supplied to the circuit 152 and subjected to frame segmentation. The datum from the frame segmentation circuit 152 is transmitted via the output terminal.

In this case, a circuit for converting $\Delta$DATA into the two -bit output datum BPL (for example, ROM) and a circuit for converting $\Delta$DATA into a one-bit output datum BPL (for example, ROM) may be provided at the adaptive encoder 148, so that the outputs BPL of these circuits may be selectively output by the selection signal SEL. In this case, the selector 150 becomes unnecessary but instead, a selector for selecting one of said two circuits should be provided at the output of the encoder 148. Besides the datum BPL, the dynamic range DR and the maximum value MAX in the block or the minimum value MIN in the block and said value MAX may be employed as additional codes to be transmitted.

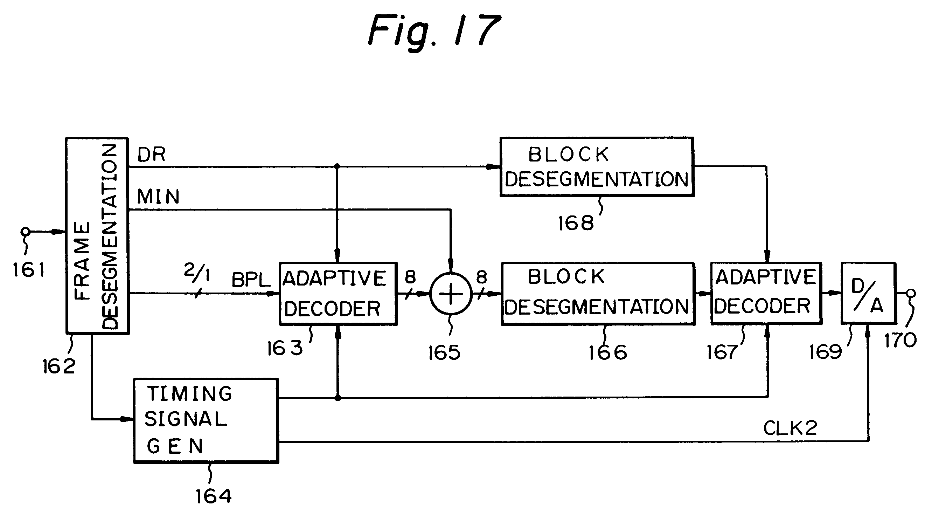

Referring to Fig. 17, a reception apparatus for data from the encoder shown in Fig. 16 is illustrated as a fourth embodiment of the invention.

The data sent is given to a frame desegmentation circuit 162 through an input terminal 161. Picture data from the circuit 162 are supplied to an adaptive decoder 163. The transmitted dynamic range DR in the block is fed to the decoder 163 from the circuit 162. The allocated bit number BITS is obtained depending on the dynamic range DR at the adaptive decoder 163 so that adaptive decoding can be made using this information BITS.

The minimum value MIN in the block from the frame desegmentation circuit 162 is supplied to an adder 165.

In this case, means I (for instance, ROM) for adaptively decoding a two-bit datum and means II (for example, ROM) for adaptively decoding a one-bit datum are provided at the adaptive decoder 163. Two bits and one bit are given to these means I and II as the allocated bit number BITS.

A signal associated with the selection signal of the selection circuit 150 on the encoder side is given from the circuit 162 to a timing signal generator 164. At the generator 164, a selection control signal in synchronism with the transmitted two-bit and one-bit pixel data is developed. The control signal is given to the decoder 163 to select the means I or the means II. Consequently, the respective two-bit pixel datum and the one-bit pixel datum are adaptively so as to produce an eight-bit difference datum $\Delta$DATA* at the adaptive decoder 163. The $\Delta$DATA* is fed to the adder 165 to provide a decoded pixel datum DATA*. Since the decoded pixel datum is a datum for each block, block desegmentation is performed at a block desegmentation circuit 166 so that said pixel datum is returned to a pixel datum of its original sequence.

A digital video signal from the circuit 166 is supplied to an adjacent-pixel-adaptive decoder 167. A dynamic range DR in a block given from the frame desegmentation circuit 162 is given to the block desegmentation circuit 168 so that the dynamic range DR is adjusted to the time sequence of the digital video signal. In other words, for each pixel data, a dynamic range DR of the block to which it belongs is given. The dynamic range DR from the circuit 168 is fed to the decoder 167. This decoder 167 corrects a pixel datum sent with two bits referring to pixel data sent with one bit and lying in its vicinity as mentioned later.

Also, in this example, the pixel datum sent with one bit is corrected referring to the pixel data in its neighborhood as mentioned later.

To select correction processing of the two-bit pixel datum or correction processing of the one-bit pixel datum in synchronizm with the input pixel data of the adjacent-pixel-adaptive decoder 167, the conversion control signal from the timing signal generator 164 is supplied to the decoder 167.

Each correction value from the decoder 167 is fed to a D/A converter 169 and converted into its original analog signal in response to the clock signal CLK2 from the timing signal generator 164 to be taken out from an output terminal 170.

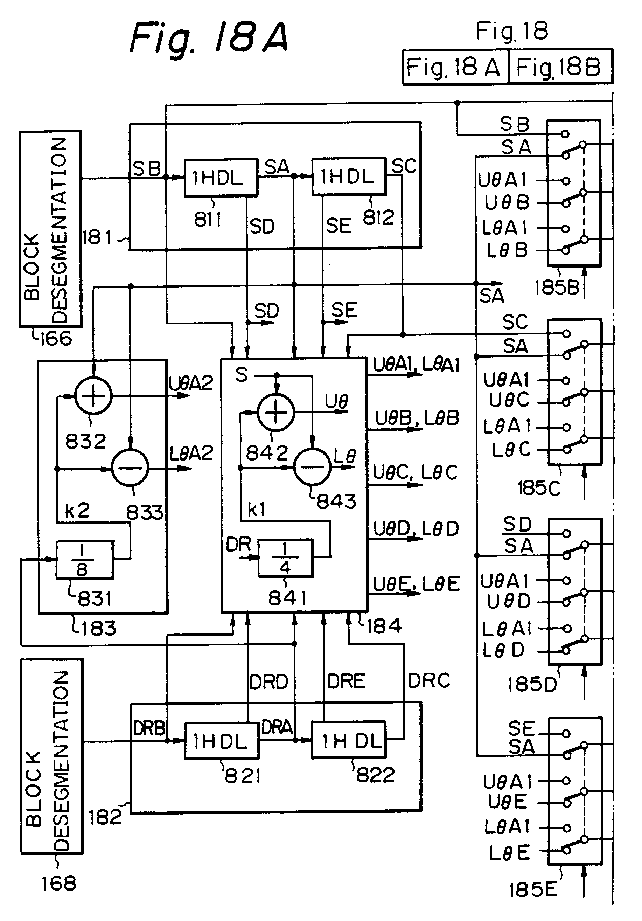

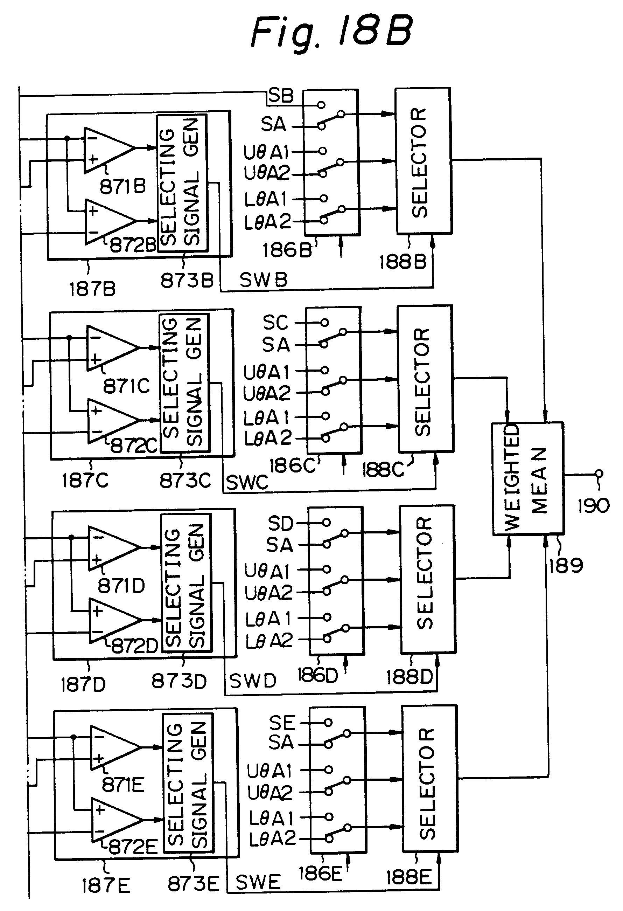

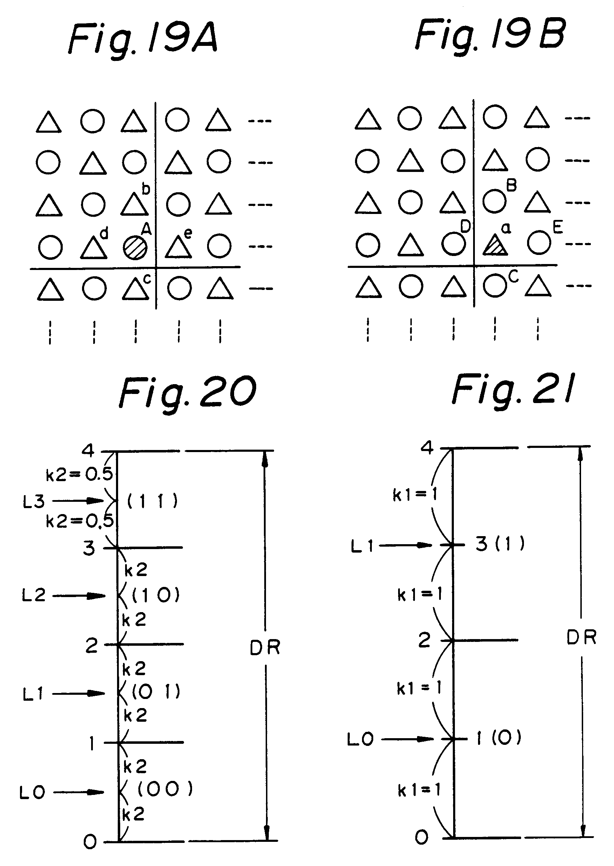

Fig. 18 shows an example of the above-mentioned adjacent-pixel-adaptive decoder 167. Description of the circuit 167 will be given referring to Figs. 19 to 21.

Referring to Fig. 18, a pixel datum (eight bits) from the block desegmentation circuit 166 is supplied to an extracting circuit 181 for peripheral pixel data. The circuit 181 is made up of serially coupled delay circuits 811 and 812 each consisting of a memory corresponding to one line pixel data. In this case, considering the pixel position of an output pixel datum SA of the delay circuit 811 to be a reference, an input pixel datum SB of the delay circuit 811 is a datum of the pixel lying just above the datum SA, an output pixel datum SC of the delay circuit 812 is a datum of the pixel lying just below the datum SA, an output datum SD lying after one pixel from the datum SC is data of the pixel adjacent to the datum SA in the left-handed direction, and a pixel datum SE prior to one pixel from the input datum SA given from the delay circuit 812 is a datum of the pixel adjacent to the datum SA in the right-handed direction.

A dynamic range DR in each of divided blocks from the block desegmentation circuit 168 is supplied to an adaptive dynamic range generator 182 for each pixel datum. The generator 182 is constructed by a series circuit of delay circuits 821 and 822 each consisting of memory of one line. As the output datum of delay circuits 821, a dynamic range DRA corresponding to the pixel datum SA is provided from the generator 182. A dynamic range DRB corresponding to the pixel datum SB is given as the input datum of the delay circuit 821 from the generator 182. Similarly, a dynamic range DRC corresponding to the pixel datum SC is provided as the output datum of the delay circuit 822, a dynamic range DRD corresponding to the pixel datum SD is generated as the output datum lying after one pixel from the output datum of the delay circuit 821, and as the output datum lying prior to one pixel of the input datum from the delay circuit 822, a dynamic range DRE corresponding to the pixel datum SE is provided, respectively.

Also, an upper limit/lower limit generator 183 provides an upper limit UQA2 and a lower limit LQA2 in the range of quantization levels when the pixel datum SA is a two-bit pixel datum shown at O of Fig. 19. The pixel datum SA from the extracting circuit 181 and the adaptive dynamic range DRA are given to the generator 183.

In addition, the upper limit/lower limit generator 184 provides the upper limits U$\theta$A1, U$\theta$B, U$\theta$C, U$\theta$D and U$\theta$E of the respective quantization level ranges of the pixel data SA, SB, SC, SD and SE and the lower limits L$\theta$A1, L$\theta$B, L$\theta$C, L$\theta$D and L$\theta$E of said ranges when those data are one-bit pixel data shown at $\Delta$ of Fig. 19. The pixel data SA, SB, SC, SD and SE and the adaptive dynamic ranges DRA, SRB, DRC, DRD and DRE from the generator 182 are supplied to the generator 184.

For example, the development of the upper and lower limits in the case of the datum BPL encoded by the non-edge matching technique will be described.

Fig. 20 shows the case of BITS = 2 in the non-edge matching technique. Fig. 21 shows the case of BITS = 1 in the same technique and the case of MIN = 0, MAX = 4.

As is clear from Figs, 20 and 21, since decoded values L0, L1, L2 and L3 are the central values of the respective quantization level ranges, the upper limit and the lower limit become the values equal to an addition or subtraction of the decoded value of its pixel and k = DR x 1/2x where x is a division number of the dynamic range DR.

$$k = DR \times 1/2^{BITS + 1}$$

In the generator 183, a corresponding dynamic range DRA with respect to the two-bit pixel datum SA from the delay circuit 821 is given to an arithmetic circuit 831 to execute a calculation of DRA x 1/8 and provide a value k2. The value k2 is supplied to an adder 832 and a subtraction circuit 833. Meanwhile, the pixel datum SA, which is a decoded value, from the extraction circuit 181 is fed to the adder 832 and the circuit 833. There-

fore, the upper limit UθA2 of the quantization level range on the datum SA is produced from the adder 832, while its lower limit LθA2 is given from the subtraction circuit 833.

Further, in the generator 184, five circuits each having an arithmetic circuit 841 for dividing a corresponding dynamic range from the generator 182 by four and another five circuits each consisting of an adder 842 and a subtraction circuit 843 for performing an addition and a subtraction between an output k1 from the circuit 841 and each pixel data from the circuit 181 are provided corresponding to the pixel data SA, SB, SC, SD and SE. Said two circuit groups produce the upper limits UθA1, UθB, UθC, UθD and UθE and the lower limits LθA1, LθB, LθC, LθD and LθE, respectively.

Also, in Fig. 18, switching circuits 185B, 185C, 185D and 185 E and 186B, 186C, 186D and 186E are switched in synchronism with pixels indicated by circles ○ of Fig. 19 and pixels indicated by triangles △ by a control signal from the timing signal generator 164. When the pixel datum SA is a pixel shown by a circle, the switching is made into the shown state, whereas when the datum is a pixel shown by a triangle △, the switching is done toward the reverse state with that shown in the drawing. Those switching circuits 185B to 185E and 186B to 186E provide pixel data and information on the upper and lower limits selectively.

Specifically, in the switching state shown in the drawing, the switching circuits 185B, 185C, 185D and 185E provide the pixel datum SA, the upper limits UθB, UθC, UθD and UθE and the lower limits LθB, LθC, LθD and LθE, respectively.

Moreover, the switching circuits 186B, 186C, 186D and 186E give the pixel datum SA and the upper limits UθA2 and the lower limit LθA2, respectively.

On the other hand, in the reversely switched state with that shown in the drawing, the switching circuits 185B, 185C, 185D and 185E provide the pixel data SB, SC, SD and SE, the upper limit UθA1 and the lower limit LθA1, respectively.

In addition, the switching circuits 186B, 186C, 186D and 186E give the pixel data SB, SC, SD and SE, the upper limit UθA1 and the lower limit LθA1, respectively.

Decision circuits 187B, 187C, 187D and 187E are made up of comparators 871B, 871C, 871D and 871E for comparing the outputs of the switching circuits 185B, 185C, 185D and 185E and information on the upper limits, comparators 872B, 872C, 872D and 872E for comparing said outputs of the circuits 185B to 185E and information on the lower limits, and selection signal generators 873B, 873C, 873D and 873E for generating selection signals SWB, SWC, SWD and SWE for selectors 188B, 188C, 188D and 188E, which will be mentioned later, in response to the outputs of the above-mentioned comparators.

The selectors 188B, 188C, 188D and 188E select one of three data, i.e., a pixel datum, upper limit and lower limit given from the switching circuits 186B, 186C, 186D and 186E based on the selection signals provided by the decision circuits 187B, 187C, 187D and 187E and send the selected one datum to a weighted mean circuit 189.

The weighted mean circuit 189 adequately performs the weighting of the outputs of the selectors 188B, 188C, 188D and 188E, calculates the mean value of the weighted values, and produces the mean value to an output terminal 190 as a correction pixel datum.

Next, an adaptive decoding operation of the above-mentioned adjacent pixel adaptive decoder will be explained.

First, description will be given to the case where a two-bit pixel datum indicated by a circle ○ in Fig. 19 is corrected by referring to one-bit pixel data indicated by triangles △.

In the following description, the case where the decoded value of a pixel A at the position indicated with hatching in a circle sent with two bits is corrected with pixels b, c, d and e in its vicinity sent with one bit indicated by triangles △ is taken as one example. In Fig. 19, a thin line shows a block dividing line, and in Fig. 19A, the pixels A, b and d belong to the same block, whereas the pixels e and c belong to separate blocks.

Now it is considered that the pixel datum SA from the extracting circuit 181 is a datum of a two-bit pixel A shown by an circle in Fig. 19A. In this case, the pixel data SB, SC, SD and SE become the one-bit pixels b, c, d and e shown by triangles. For convenience of explanation, it is assumed that these are pixel data Sb, Sc, Sd and Se

In this state, the switching circuits 185B, 185C, 185D and 185E and 186B, 186C, 186D and 186E are switched into the state shown in the drawing.

As a result, at the decision circuit 187B, the reception pixel datum Sa is compared with the upper limit UθB of a quantization level range of the datum Sb of the pixel b and with the lower limit LθB of said range in the comparators 871B and 872B, and decisions are made on: whether the pixel datum SA lies in the quantization level range; whether it is larger than the upper limit UθB; and whether it is smaller than the lower limit LθB. On the basis of said decisions, the selection signal SWB is obtained from the selection signal generator 873B. The reception pixel datum SA is directly given from the selector 188B by said selection signal SWB when the datum SA lies in the quantization level range of the datum Sb. When the datum SA is larger than the upper limit UQB, the upper limit $U\theta A2$ of a quantization level range of the reception pixel datum SA is provided from the selector 188B, while the lower limit of said range of the datum SA is obtained when the datum SA is smaller than the lower limit $L\theta B$.

When the reception pixel datum SA lies outside of the quantization level range of the pixel datum Sb, providing the upper limit $U\theta A2$ or the lower limit $L\theta A2$ of the quantization level range of the datum SA is because it is considered that a correction value of the pixel b in the vicinity of the datum SA lies in the quantization level range of the datum SA.

Similarly, at the decision circuits 187C, 187D and 187E, the reception pixel datum SA is compared with the upper limits $U\theta C$, $U\theta D$ and $U\theta E$ of the quantization level ranges of the data Sc, Sd and Se of the pixels c, d and e and their lower limits $L\theta C$, $L\theta D$ and $L\theta E$, and decisions are made on: whether the datum SA lies in the quantization level ranges of the data Sc, Sd and Se; whether it is larger than the upper limits $U\theta C$, $U\theta D$ and $U\theta E$; and whether it is smaller than the lower limits $L\theta C$, $L\theta D$ and $L\theta E$. As their decision outputs, the selection signals SWC, SWD and SWE are produced. By these selection signals, the datum SA itself is obtained from the selectors 188C, 188D and 188E when the datum SA lies in the quantization level ranges of the data Sc, Sd and Se. When the datum SA is greater than the upper limits $U\theta C$, $U\theta D$ and $U\theta E$, the upper limit $U\theta A2$ of the quantization level range of the datum SA is obtained, whereas the lower limit $L\theta A2$ of the quantization level range of the datum SA is provided whether the datum is smaller than the lower limits $L\theta C$, $L\theta D$ and $L\theta E$.

A correction pixel datum thus obtained from the selectors 188B, 188C, 188D and 188E is supplied to the weighted mean circuit 189 where a weighted mean is calculated. As a result, a correction value of the pixel datum SA is lead from the output terminal 190.

Here, weighting coefficients at the circuit 189 are selected so that those having strong correlation with the pixel A are approaching 1 by referring to distances between the pixel A and the peripheral pixels b, c, d and e, etc.

In this case, if the decoded value of the pixel A is L3 = 3.5 in Fig. 20 and the decoded values of its peripheral pixels b, c, d and e are all L1 = 3 in Fig. 21, all the outputs of the selectors 188B, 188C, 188D and 188E assume L3 = 3.5. As a result, the output of the weighted mean circuit 189 becomes nearly 3.5. If simple mean is calculated, the correction value is quite equal to 3.5.

Also, when the decoded value of the pixel A is L3 = 3.5 in Fig. 20, the decoded values of the peripheral pixels b, c and d are L1 = 3 in Fig. 21, the decoded value of the pixel e is L0 = 1 in Fig. 21, the decoded value L3 = 3.5 of the pixel A is obtained from each of the selectors 188B, 188C and 188D as it is. The lower limit $L\theta A2 = 3$ that can take the decoded value L3 in Fig. 20 is obtained from the selector 185E in place of the decoded value 1. The correction value of the decoded value of the pixel A is $(3.5 \times 3 + 3)/4 = 3.375$.

Next, it is considered that the output pixel datum of the extracting circuit 181 is a one-bit datum of the pixel a indicated at $\triangle$ with hatching in Fig. 19B. In this case, the pixel data SB, SC, SE and SE of the circuit 181 are two-bit data of its peripheral pixels B, C, D and E in Fig. 19B. For simplicity of explanation, it is assumed that a datum of the pixel a and data of the pixels B, C, D and E are Sa and SB, SC, SD and SE, respectively.

In this state, the switch circuits 185B, 185C, 185D, 185E and 186B, 186C, 186D, 186E are switched in the reverse state with the state shown in the drawing.

As a result, at each of the decision circuits 187B, 187C, 187D and 187E, decisions are made on: the levels of the respective input pixel data SB, SC, SD and SE lie within a range W of a quantization level of the pixel datum Sa: whether they have higher than the upper limit $U\theta A1$ in the range W; and whether they have lower than the lower limit $L\theta A1$ in the range W. On the basis of said decisions, the selection signal generators 873B, 873C, 873D and 873E generate the selection signals SWB, SWC, SWD and SWE.

The selectors 188B, 188C, 188D and 188E are controlled by the selection signals SWB, SWC, SWD and SWE given from the decision circuits 187B, 187C, 187D and 187E. When the levels of the input pixel data SB, SC, SD and SE lie in the range W of the the quantization level of the pixel datum Sa, the input pixel data SB, SC, SD and SE are directly obtained from the selectors 188B, 188C, 188D and 188E. Also, when said levels lie out of the range W and are larger than the upper limit $U\theta A1$, this limit $U\theta A1$ is given from the selectors 188B, 188C, 188D and 188E, whereas when said levels lie out of the range W and are smaller than the lower limit $L\theta A1$, this lower limit $L\theta A1$ is provided from the selectors 188B, 188C, 188D and 188E.

The outputs of these selectors are supplied to the weighted mean circuit 189. In a manner similar to that mentioned above, this circuit performs the weighting of the outputs of the selectors 188B, 188C, 188D and 188E and produces their average value by calculation in consideration of the strength of correlation between the pixel a and its neighboring pixels B, C, D and E. In this way, the correction datum of the pixel a is provided from said circuit 189.

In this case, when the decoded value of the pixel a is L1 = 3 in Fig. 21 and each of the decoded values of its peripheral pixels B, C, D and E is L3 = 3.5 in Fig. 20, all the outputs of the selectors 188B, 188C, 188D and 188E assume L3. As a result, the output of the weighted mean circuit 189 almost becomes L3 = 3.5. With simple mean, the correction value becomes 3.5.

Further, when the decoded value of the pixel a is L1 = 3 in Fig. 21, each of the decoded values of the pixels B, C and D among the peripheral pixels is L3 = 3.5 and the decoded value of the pixel E is L0 = 0.5 in Fig. 20, the selectors 188B, 188C and 188D give the decoded values L3 = 3.5 directly. The selector 188E provides the lower limit L$\theta$A1 = 2 which can take the decoded value L1 in Fig. 21, in place of the decoded value 0.5. This is because it is considered that the decoded value of the pixel a exists only in the quantization level range of the decoded value L1 when the decoded value of the pixel a is L1. At this time, the correction value of the decoded value of the pixel a is (3.5 x 3 + 2)/4 = 3.125.

Similarly, when the decoded value of a pixel a is L0 = 1 as shown in Fig. 21 and when any one of the peripheral pixels B, C, D and E is larger than the upper limit of the decoded value L0, the maximum value existing as decoded values of the pixel a, that is, the upper limit U$\theta$A1 of its quantization level range is used in place of the decoded values of the pixels B, C, D and E.

Although the foregoing is directed to the non-edge matching case, the values k2 and k1 can be produced by calculating an operation of DR x $1/(2^{BITS + 1} -2)$ in the arithmetic circuits 831 and 841 of the upper limit/lower limit generators 183 and 184 in the edge matching case. In this case, if the decoded value is the maximum value MAX or the minimum value MIN, the upper limit and the lower limit are likely to be larger than MAX by k1 or k2 or smaller than MIN by k1 or k2 when these upper limit and lower limit are obtained by an addition or subtraction between said decoded value and k1 or k2. For this reason, the generators 183 and 184 produce said MAX and MIN as the upper limit and the lower limit when the decoded value is the MAX and MIN. At this time, the MIN is provided by the block desegmentation of the minimum value MIN in the block from the frame desegmentation circuit 162, and the MAX is given by the sum of the dynamic range DR subjected to block desegmentation and the minimum value MIN subjected to block desegmentation.

Although data having a large bit number and data having a low bit number are sent in a line-quincunx fashion as shown in Fig. 19 in the above-mentioned embodiments, they may be transmitted by periodically switching those data.

Also, the bit number may be changed for every plural pixels in place of varying said number for every one pixel. Further, the bit number of one pixel or plural pixels may by changed for every plural pixels. In addition, three or more kinds of bit numbers may be selectively used instead of the above-mentioned two kinds.

Also, only pixels lying at the upper, lower, left-handed and right-handed portions are referred to as peripheral pixels in the above embodiments. However, when pixels having small and large bits in the diagonal direction, a correction value may be obtained by taking the weighted mean. Even in this case, the weighted mean is calculated by weighting the pixels in the diagonal direction in consideration of the distances between these pixels in the diagonal direction and the objective pixel to be corrected and so on.

According to the present embodiment, in the reception of a digital video signal transmitted in the well-balanced compression in the space direction and in the level direction, a pixel datum with a large bit number is decoded referring to pixel data lying in its neighborhood and having small bit numbers. As a result, noises appearing on a picture due to a difference of bit numbers are subdued to provide an exellent reception picture.

## Claims

1. A decoding apparatus for decoding coded data transmitted from a coding apparatus, said decoding apparatus comprising:

    fetching means (2,45) for providing, from data input to the fetching means (2,45), input data ($Q_1$-$Q_8$) adjacent an input datum ($Q_I$) to be decoded;

    comparator means (11,12-19;46) for comparing individually with the input datum ($Q_I$) to be decoded each of said adjacent input data ($Q_1$-$Q_8$) provided by said fetching means (2,45) and providing an output for each comparison;

    generating means (20,23;47,48) supplied with each output of said comparator means (11,12-19;46) for generating on the basis of all of said outputs a correcting datum; wherein in use said decoding apparatus decodes said input datum on the basis of said input datum and said correcting datum.

2. A decoding apparatus according to claim 1, for use with coded data having fewer bits than corresponding original uncoded data.

3. A decoding apparatus according to claim 1 or 2, wherein said coded data includes digitized video data and said fetching means (2) includes line delay means (3,4) for delaying a datum for one line period and data delay means (5-10) for delaying a datum for one datum period.

**4.** A decoding apparatus according to claim 1, 2 or 3 for use with digital video data coded in a block format, the block format coding allowing compression of the block data representing a group of picture elements, said coded data having an additional code for each of said respective blocks, said additional code being formed of at least two of the maximum value, the minimum value, and a signal corresponding to dynamic range information of digital video data of said picture elements in said block.

**5.** A decoding apparatus according to claim 4, wherein in use said fetching means (45) provides adjacent input data in the same block as that to which said input datum to be decoded belongs, said decoding apparatus further comprising adder means (49) for adding said correcting datum to said input datum, means (50) for decoding the output of said adder means (49) according to said dynamic range information, and mixing means (51) for mixing the decoded output of said adder means (49) and one of said maximum and minimum values.

**6.** A decoding apparatus according to claim 4, comprising means for partially decoding transmitted data according to said dynamic range information and block separation means (52) for forming said data input to the fetching means (45) by arranging said partially decoded data into TV scanning order.

**7.** A decoding apparatus according to claim 6 further comprising an adder for adding the partially decoded datum output from said block separation means and said correcting datum.

**8.** A decoding apparatus according to claim 7, wherein said comparator means (46) compares the sum of the partially decoded datum and a half of a quantization step with the adjacent partially decoded data.

**9.** A decoding apparatus according to claim 2, for use with coded data having a first number of bits and a second number of bits in an alternate and cyclical fashion.

**Patentansprüche**

**1.** Dekodierungseinrichtung zum Dekodieren kodierter Daten, die von einem Kodierer übertragen werden, umfassend:

eine Abrufvorrichtung (2, 45) zum Bereitstellen von Eingangsdaten (Q1-Q8), die einem zu dekodierenden Eingangsdatum (Qi) benachbart sind, aus den Eingangsdaten der Abrufvorrichtung (2, 45);

eine Vergleichsvorrichtung (11, 12-19; 46) zum einzelnen Vergleichen des zu dekodierenden Eingangsdatums (Qi) mit jedem der benachbarten Eingangsdaten (Q1-Q8), die von der Abrufvorrichtung (2, 45) bereitgestellt werden, und zum Bereitstellen eines Ausgangssignals für jeden Vergleich;

eine Generatorvorrichtung (20, 23; 47, 48), der jedes Ausgangssignal der Vergleichsvorrichtung (11, 12-19; 46) zugeführt wird, zum Erzeugen eines Korrekturdatums auf der Basis aller Ausgangssignale, wobei im Betrieb die Dekodierungseinrichtung das Eingangsdatum auf der Basis des Eingangsdatums und des Korrekturdatums dekodiert.

**2.** Dekodierungseinrichtung nach Anspruch 1 zur Verwendung mit kodierten Daten, die weniger Bits als die entsprechenden ursprünglichen unkodierten Daten aufweisen.

**3.** Dekodierungseinrichtung nach Anspruch 1 oder 2, wobei die kodierten Daten digitalisierte Videodaten enthalten, und die Abrufvorrichtung (2) eine Zeilen-Verzögerungsvorrichtung (3, 4) zum Verzögern eines Datums für eine Zeilenperiode und eine Daten-Verzögerungsvorrichtung (5-10) zum Verzögern eines Datums für eine Datumsperiode umfaßt.

**4.** Dekodierungseinrichtung nach Anspruch 1, 2 oder 3 zur Verwendung mit im Blockformat kodierten digitalen Videodaten, wobei die Blockformat-Kodierung eine Komprimierung der Blockdaten erlaubt, die eine Gruppe von Bildelementen darstellen, wobei die kodierten Daten einen zusätzlichen Kode für jeden der jeweiligen Blöcke aufweisen, wobei der zusätzliche Kode aus zumindest zwei der folgenden Werte gebildet ist: Maximalwert, Minimalwert und einem Signal, das der Dynamikbereich-Information der digitalen Videodaten der Bildelemente im Block entspricht.

**5.** Dekodierungseinrichtung nach Anspruch 4, wobei im Betrieb die Abrufvorrichtung (45) benachbarte Eingangsdaten vorsieht im gleichen Block wie derjenige zu dem das zu dekodierende Eingangsdatum gehört, wobei die Dekodierungseinrichtung weiterhin umfaßt: einen Addierer (49) zum Addieren des Korrekturdatums auf das Eingangsdatum, eine Vorrichtung (50) zum Dekodieren des Ausgangssignals des Addierers (49) entsprechend der Dynamikbereich-Information, und eine Mischvorrichtung (51) zum Mischen des dekodierten Ausgangssignals des Addierers (49) mit dem Maximalwert oder dem Minimalwert.

6. Dekodierungseinrichtung nach Anspruch 4 mit einer Vorrichtung zum teilweisen Dekodieren übertragener Daten entsprechend der Dynamikbereich-Information und einer Block-Trennvorrichtung (52) zum Formen der Eingangsdaten für die Abrufvorrichtung (45), indem die teilweise dekodierten Daten für die Fernseh-Abtastung in die richtige Reihenfolge gebracht werden.

7. Dekodierungseinrichtung nach Anspruch 6 desweiteren mit einem Addierer zum Addieren des von der Block-Trennvorrichtung ausgegebenen teilweise dekodierten Datums auf das Korrekturdatum.

8. Dekodierungseinrichtung nach Anspruch 7, wobei die Vergleichsvorrichtung (46) die Summe aus teilweise dekodiertem Datum und der Hälfte eines Quantisierungsschritts mit den benachbarten teilweise dekodierten Daten vergleicht.

9. Dekodierungseinrichtung nach Anspruch 2 zur Verwendung mit kodierten Daten mit einer ersten Anzahl von Bits und einer zweiten Anzahl von Bits in abwechselnder und zyklischer Weise.

## Revendications

1. Appareil de décodage pour décoder des données codées émises par un appareil de codage, ledit appareil de décodage comprenant :

un moyen d'extraction (2, 45) pour fournir, par une entrée de données dans le moyen d'extraction (2, 45), des données ($Q_1$ - $Q_8$) voisines d'une donnée d'entrée ($Q_i$) à décoder ;

un moyen comparateur (11, 12-19 ; 46) pour comparer individuellement à la donnée d'entrée ($Q_i$) à décoder chacune desdites données d'entrée voisines ($Q_1$ - $Q_8$) fournies par ledit moyen d'extraction (2, 45) et pour fournir un signal de sortie pour chaque comparaison ;

un moyen générateur (20, 23 ; 47, 48) recevant chacun des signaux de sortie dudit moyen comparateur (11, 12-19 ; 46) pour générer une donnée de correction selon l'ensemble desdits signaux de sortie ; dans lequel ledit appareil de décodage en fonctionnement décode ladite donnée d'entrée selon ladite donnée d'entrée et ladite donnée de correction.

2. Appareil de décodage selon la revendication 1, destiné à des données codées comportant moins de bits que les données non codées initiales correspondantes.

3. Appareil de décodage selon l'une quelconque des revendications 1 et 2, dans lequel lesdites données codées incluent des données vidéo sous forme numérique et ledit moyen d'extraction (2) inclut un moyen à retard de ligne (3, 4) pour retarder une donnée pendant la période d'une ligne et un moyen à retard de données (5-10) pour retarder une donnée pendant la période d'une donnée.

4. Appareil de décodage selon l'une quelconque des revendications 1 à 3, destiné à des données vidéo *numériques codées dans un format par blocs, le codage* dans un format par blocs permettant la compression des données par blocs représentant un groupe d'éléments d'image, lesdites données codées comportant un code supplémentaire pour chacun desdits blocs respectifs, ledit code supplémentaire étant constitué d'au moins deux de la valeur maximale, de la valeur minimale et d'un signal correspondant à des informations de plage dynamique des données vidéo numériques desdits éléments d'image dans ledit bloc.

5. Appareil de décodage selon la revendication 4, dans lequel ledit moyen d'extraction (45) en fonctionnement fournit des données d'entrée voisines dans le même bloc que celui auquel appartient ladite donnée d'entrée à décoder, ledit appareil de décodage comprenant en outre un moyen additionneur (49) pour ajouter ladite donnée de correction à ladite donnée d'entrée, un moyen (50) pour décoder le signal de sortie dudit moyen additionneur (49) selon lesdites informations de plage dynamique, et un moyen mélangeur (51) pour mélanger le signal décodé de sortie dudit moyen additionneur (49) et une desdites valeurs maximale et minimale.

6. Appareil de décodage selon la revendication 4, comprenant un moyen pour décoder partiellement des données émises selon lesdites informations de plage dynamique et un moyen séparateur de bloc (52) pour former lesdites données entrées dans le moyen d'extraction (45) en disposant lesdites données décodées partiellement dans un ordre de balayage TV.

7. Appareil de décodage selon la revendication 6, comprenant en outre un additionneur pour additionner la donnée partiellement décodée de sortie dudit moyen séparateur de bloc et ladite donnée de correction.

8. Appareil de décodage selon la revendication 7, dans lequel ledit moyen comparateur (46) compare la somme de la donnée décodée partiellement et d'une moitié d'un pas de quantification aux données partiellement décodées voisines.

9. Appareil de décodage selon la revendication 2, destiné à des données codées comportant un premier nombre de bits et un second nombre de bits d'une manière alternée et cyclique.

*Fig. 1*

# Fig. 2A

| | | |
|---|---|---|
| Q1 | Q2 | Q3 |
| Q4 | Qi | Q5 |
| Q6 | Q7 | Q8 |

# Fig. 2B

| | | |
|---|---|---|
| 1 | 1 | 1 |
| 1 | 2 | 1 |
| 1 | 1 | 1 |

# Fig. 2C

| | | |
|---|---|---|
| 3 | 3 | 3 |
| 3 | 2 | 3 |
| 3 | 3 | 3 |

# Fig. 3

+8

O

−8

# Fig. 5

| y LINES

| x PIXELS |

## Fig. 4

```
31 ──▶ BLOCK          ──▶ MAX            MAX
        SEGMENTATION       DETECTION    ┌ +    DR
        32                 33           │ ◯ ── ──────────────▶ FRAME
                                        36 −                   SEGMENTATION
                           MIN          MIN                    40
                           DETECTION ───────────────────────▶  39
                           34
                                        37
                    35 ─▶ D L        ┌ −     38
                                  + ◯ ──▶ QUANTIZATION ──▶ DT
                                    PDI
```

## Fig. 6A

```
MAX ┬
    │
1 1 │ ●
    │       ▲
1 0 │ ●     │ DR
    │       │
0 1 │ ●     │
    │       │
0 0 │ ●     ▼
    │
MIN ┴
```

## Fig. 6B

```
MAX ┬ ●
    │       ▲
1 1 │       │
    │       │
1 0 │ ●     │
    │       │ DR
0 1 │ ●     │
    │       │
0 0 │       │
    │       ▼
MIN ┴ ●
```

## Fig. 8

```
MAX ── 66
1 1
    ── 62
1 0
    ── 58
0 1
    ── 54
0 0
MIN ── 50
```

Fig. 7

Fig. 9

# Fig. 10

# Fig. 11A    Fig. 11B

## Fig. 12

Fig.13A CLK1

Fig.13B SH

Fig.13C PT

Fig.13D LA

Fig.13E SEL

## *Fig. 14*

## *Fig. 15*

*Fig. 16*

EP 0 327 322 B1

# Fig. 17

# Fig. 18A

Fig. 18

| Fig. 18 A | Fig. 18 B |

# Fig. 18B

# Fig. 19A

# Fig. 19B

# Fig. 20

# Fig. 21